# EUROPEAN PATENT SPECIFICATION

(11) **EP 3 288 291 B1**
(45) Date of publication and mention of the grant of the patent: **26.05.2021**
(21) Application number: 16783024.9
(22) Date of filing: 08.04.2016
(51) Int. Cl.: H01L 41/053, H01L 41/047, B06B 1/06, H01L 41/083, G01S 7/521, G01S 15/931

(54) **ULTRASONIC SENSOR**
ULTRASCHALLSENSOR
CAPTEUR ULTRASONORE

(30) Priority: 20.04.2015 JP 2015085656
(43) Date of publication of application: 28.02.2018
(73) Proprietor: Murata Manufacturing Co., Ltd., Nagaokakyo-shi, Kyoto 617-8555 (JP)
(72) Inventor: TAKAHASHI, Masaki, Nagaokakyo-shi Kyoto 617-8555 (JP)
(74) Representative: Reeve, Nicholas Edward
(86) International application number: PCT/JP2016/061504
(87) International publication number: WO 2016/171003

(56) References cited:
- EP-A2- 0 874 351
- JP-A- S6 477 299
- JP-A- H01 270 499
- JP-A- 2005 039 689
- JP-A- 2007 318 742
- JP-A- 2010 252 017
- JP-A- 2014 230 109
- US-A1- 2006 076 854
- US-A1- 2011 221 304

## Description

### Technical Field

The present invention relates to an ultrasonic sensor including a piezoelectric element.

### Background Art

As disclosed in Japanese Patent Laying-Open No. 2002-204497 and Japanese Patent Laying-Open No. 2000-152388, an ultrasonic sensor including a piezoelectric element is known. A general ultrasonic sensor provides a unimorph structure by bonding a piezoelectric element to an inner surface of a bottom portion of a case and transmits and receives ultrasonic waves by causing the bottom portion of the case to perform bending vibration. Such an ultrasonic sensor is, for example, provided on the front or rear of a vehicle and is utilized to assist parking or prevent unintended start. Further devices of the prior art are known from EP 0 874 351 A2, US 2011 / 0221304 A1 and US 2006 / 0076854 A1. The device of EP 0 874 351 A2 comprises an electrically insulating case and passes ultrasound through a horn, not exciting bending vibrations in a bottom portion of the casing. The devices of US 2011 / 0221304 A1 and US 2006 / 0076854 A1 do not comprise a lateral extension of the piezoelectric elements beyond a second top surface portion as defined by claim 1.

In order to achieve the function of obtaining information related to presence or absence and movement of a target (object to be detected), an ultrasonic sensor is arranged so as to be exposed to the target. A cover may be used in order to protect the ultrasonic sensor against the load (impact and the like) from the outside. In many cases, however, there is a demand to obtain a high degree of detection accuracy, and thus, a cover having sufficient strength is hardly used. Therefore, the ultrasonic sensor is often used in a state in which, when subjected to the load from the outside, the load is likely to directly act on the ultrasonic sensor.

Therefore, during traveling of a vehicle, for example, the ultrasonic sensor may be subjected to the load due to incoming small stones and the like, which may cause damage to a bottom portion (portion that receives and transmits ultrasonic waves) of a case and a piezoelectric element bonded to the bottom portion of the case (problem of chipping). Increasing a thickness of the bottom portion of the case allows suppression of the occurrence of the damage. However, simply increasing the thickness of the bottom portion of the case may lead to a reduction in amplitude (i.e., deterioration in detection accuracy).

The present invention has been made in view of the above-described circumstances, and we have appreciated that it would be desirable to provide an ultrasonic sensor in which deterioration in detection accuracy can be reduced and the occurrence of damage to a bottom portion of a case and a piezoelectric element can be suppressed as compared with conventional ultrasonic sensors.

### SUMMARY OF INVENTION

An ultrasonic sensor according to the present invention is defined by claim 1.

Preferably, the piezoelectric element is of multilayer type and in a plan view of the second electrode, the first top surface portion and the second top surface portion along the direction perpendicular to the second top surface portion, an end portion of the second electrode located on the bonding surface side is located to overlap with the first top surface portion without overlapping with the second top surface portion.

Preferably, the piezoelectric element has: a piezoelectric layer including a transmission region and a reception region; a common electrode having a shape extending over both the transmission region and the reception region; a transmission electrode opposing the common electrode with the transmission region interposed therebetween; and a reception electrode opposing the common electrode with the reception region interposed therebetween, and the transmission region and the reception region are formed at positions adjacent to each other in a surface direction of the second top surface portion.

According to the above-described configuration, the protruding portion is provided on the bottom portion and the bottom portion has a thickness greater by a thickness of the protruding portion, and thus, the occurrence of damage can be suppressed. Simply increasing the thickness of the bottom portion may lead to a reduction in amplitude (i.e., deterioration in detection accuracy). However, in the above-described ultrasonic sensor, the protruding portion is provided at the position distanced from the cylindrical portion of the case. Since the rigidity of the portion close to a node of vibration is reduced, the reduction in amplitude (i.e., deterioration in detection accuracy) can be suppressed. Accordingly, there can be provided an ultrasonic sensor in which deterioration in detection accuracy can be reduced and the occurrence of damage to a bottom portion of a case and a piezoelectric element can be suppressed as compared with conventional ultrasonic sensors.

### BRIEF DESCRIPTION OF DRAWINGS

Fig. 1 is a diagram illustrating functional blocks of a sensor device including an ultrasonic sensor in a first embodiment.
Fig. 2 is a cross-sectional view illustrating the ultrasonic sensor in the first embodiment.
Fig. 3 is a cross-sectional view when seen in an arrow direction along a line III-III in Fig. 2.
Fig. 4 is a perspective view illustrating a cross-sectional structure of a case included in the ultrasonic sensor in the first embodiment.
Fig. 5 is a plan view illustrating a piezoelectric element and a flexible printed circuit (FPC) included in the ultrasonic sensor in the first embodiment.
Fig. 6 is a plan view illustrating the piezoelectric element (in a state in which the FPC is detached) included in the ultrasonic sensor in the first embodiment.
Fig. 7 is a perspective view illustrating the piezoelectric element included in the ultrasonic sensor in the first embodiment.
Fig. 8 is a perspective view illustrating the piezoelectric element included in the ultrasonic sensor and the internal structure thereof in the first embodiment.
Fig. 9 is a perspective view illustrating electrodes included in the piezoelectric element of the ultrasonic sensor in the first embodiment.
Fig. 10 is a cross-sectional view when seen in an arrow direction along a line X-X in Fig. 6 (and Fig. 3).
Fig. 11 is a cross-sectional view when seen in an arrow direction along a line XI-XI in Fig. 6 (and Fig. 3).
Fig. 12 is a cross-sectional view when seen in an arrow direction along a line XII-XII in Fig. 6 (and Fig. 3).
Fig. 13 is a cross-sectional view illustrating a case and the like included in an ultrasonic sensor in a modification of the first embodiment.
Fig. 14 is a cross-sectional view illustrating a case and the like included in an ultrasonic sensor in a second embodiment.
Fig. 15 is a cross-sectional view illustrating a case and the like included in an ultrasonic sensor in a third embodiment.
Fig. 16 is a cross-sectional view illustrating a case and the like included in an ultrasonic sensor in a fourth embodiment.
Fig. 17 is a cross-sectional view illustrating a case and the like included in an ultrasonic sensor in a fifth embodiment.

### DESCRIPTION OF EMBODIMENTS

Embodiments based on the present invention will be described hereinafter with reference to the drawings. When the number and an amount of components are referred, the scope of the present invention is not necessarily limited to the number and the amount of them unless otherwise specified. The same reference numerals denote the same components and equivalent components and overlapped description thereof is not repeated in some cases.

### First Embodiment

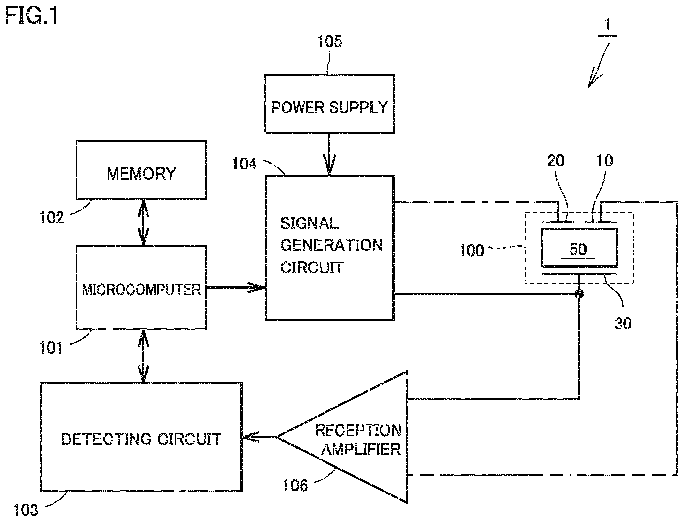

Fig. 1 is a diagram illustrating functional blocks of a sensor device 1 including an ultrasonic sensor 100 in a first embodiment. Sensor device 1 includes ultrasonic sensor 100, a microcomputer 101, a memory 102, a detecting circuit 103, a signal generation circuit 104, a power supply 105, and a reception amplifier 106. Ultrasonic sensor 100 includes a piezoelectric element 50, and piezoelectric element 50 has a three-terminal structure formed of electrodes 10, 20, and 30.

Microcomputer 101 reads out data stored in memory 102 and outputs a control signal to signal generation circuit 104. Signal generation circuit 104 generates an alternating-current (AC) voltage from the DC voltage based on the control signal. The AC voltage is supplied to ultrasonic sensor 100 and ultrasonic waves are transmitted into the air or the like from ultrasonic sensor 100. When ultrasonic sensor 100 receives reflected waves from a target, a reception signal generated in ultrasonic sensor 100 as a voltage value is transmitted to reception amplifier 106 and is input to microcomputer 101 through detecting circuit 103. Information related to presence or absence and movement of the target can be grasped with microcomputer 101.

### (Ultrasonic Sensor 100)

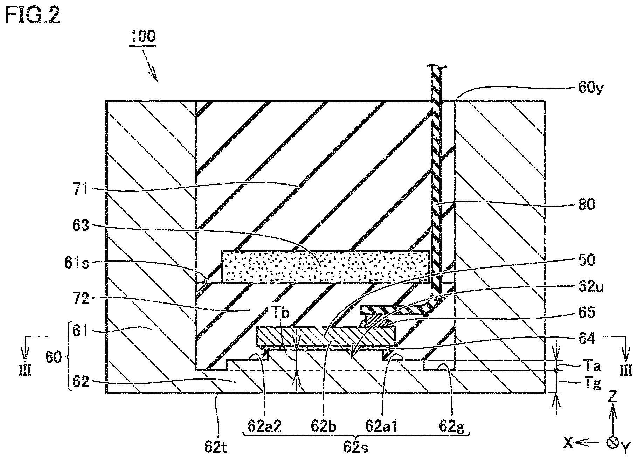

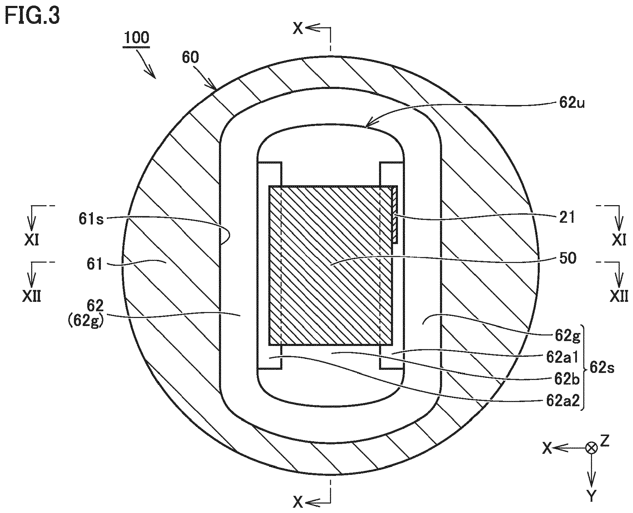

Fig. 2 is a cross-sectional view illustrating ultrasonic sensor 100 in the first embodiment. Fig. 3 is a cross-sectional view when seen in an arrow direction along a line III-III in Fig. 2. Referring to Fig. 2 and Fig. 3 (referring mainly to Fig. 2), ultrasonic sensor 100 includes piezoelectric element 50, a case 60, a sound absorbing material 63, an adhesive 64, a bonding agent 65, fillers 71 and 72, and a flexible printed circuit (FPC) 80. For the convenience of illustration, Fig. 3 does not illustrate adhesive 64 and filler 72.

### (Case 60)

Case 60 is formed of a member having conductivity and is made of aluminum that has high elasticity and is lightweight, for example. Case 60 is produced by performing forging processing or cutting processing on aluminum, for example. Case 60 is formed to have a cylindrical shape with a bottom, and includes a bottom portion 62 and a cylindrical portion 61 provided to stand from a peripheral edge of bottom portion 62. An opening 60y is formed in a portion of cylindrical portion 61 of case 60 opposite to bottom portion 62 (Fig. 2).

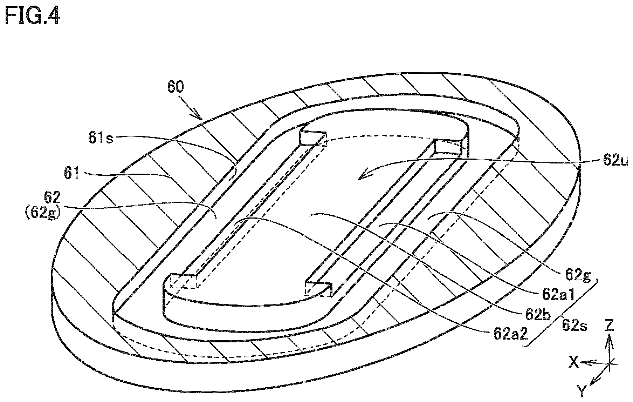

Bottom portion 62 of case 60 has an inner surface 62s and an outer surface 62t. Piezoelectric element 50 is bonded to inner surface 62s. Fig. 4 is a perspective view illustrating a cross-sectional structure of case 60. As illustrated in Fig. 2 to Fig. 4, one protruding portion 62u is provided on bottom portion 62 of case 60. Protruding portion 62u is formed at a position distanced from an inner circumferential surface 61s of cylindrical portion 61. Protruding portion 62u has such a shape that a part of bottom portion 62 protrudes toward the opening 60y side at the position distanced from inner circumferential surface 61s of cylindrical portion 61.

As illustrated in Fig. 3, in a plan view of protruding portion 62u and inner circumferential surface 61s of cylindrical portion 61 along an axial direction (direction perpendicular to an annular groove portion 62g) of case 60, the shape of a peripheral edge of protruding portion 62u and the shape of inner circumferential surface 61s of cylindrical portion 61 have a substantially similarity relation. Annular groove portion 62g is formed around protruding portion 62u (between the peripheral edge of protruding portion 62u and inner circumferential surface 61s of cylindrical portion 61).

Protruding portion 62u has a top surface on the opening 60y side. The top surface of protruding portion 62u in the present embodiment includes first top surface portions 62a1 and 62a2 and a second top surface portion 62b. That is to say, inner surface 62s of bottom portion 62 in the present embodiment is configured by annular groove portion 62g, first top surface portions 62a1 and 62a2, and second top surface portion 62b.

Annular groove portion 62g, first top surface portions 62a1 and 62a2, and second top surface portion 62b each has a flat plane shape and are parallel to one another (see Fig. 2). As illustrated in Fig. 3, in a plan view of first top surface portions 62a1 and 62a2 along the axial direction of case 60, first top surface portions 62a1 and 62a2 are located at an end portion on one side (on the right side in the figure) in a shorter side direction of protruding portion 62u and at an end portion on the other side (on the left side in the figure) in the shorter side direction of protruding portion 62u, respectively, and each has a rectangular shape and extends in parallel along a top-and-bottom direction in the figure.

Assuming that a protrusion height refers to a distance from annular groove portion 62g in the axial direction (direction perpendicular to annular groove portion 62g) of case 60, each of first top surface portions 62a1 and 62a2 has a protrusion height Ta (Fig. 2) and second top surface portion 62b has a protrusion height Tb (Fig. 2). A value of protrusion height Tb is larger than a value of protrusion height Ta. In other words, second top surface portion 62b has a protrusion height higher than that of each of first top surface portions 62a1 and 62a2. When first top surface portions 62a1 and 62a2 are seen with respect to second top surface portion 62b, first top surface portions 62a1 and 62a2 have a shape recessed in a concave manner from second top surface portion 62b.

### (Piezoelectric Element 50)

Referring again to Fig. 2, piezoelectric element 50 is made of PZT-based ceramics, for example. Piezoelectric element 50 is arranged on inner surface 62s (specifically, on second top surface portion 62b) of bottom portion 62 and is bonded to inner surface 62s (second top surface portion 62b) using adhesive 64. Adhesive 64 is an epoxy-based adhesive, for example. When ultrasonic sensor 100 is driven, piezoelectric element 50 performs bending vibration together with bottom portion 62.

As illustrated in Fig. 3, in the present embodiment, a part of piezoelectric element 50 (such as an end face portion 21 of electrode 20 described later) is located to project from second top surface portion 62b. However, the present invention is not limited to this configuration, and piezoelectric element 50 as a whole may be located on second top surface portion 62b without projecting from second top surface portion 62b. That is to say, in a plan view of piezoelectric element 50 and second top surface portion 62b along the direction perpendicular to second top surface portion 62b, piezoelectric element 50 may be arranged such that at least a part thereof overlaps with second top surface portion 62b.

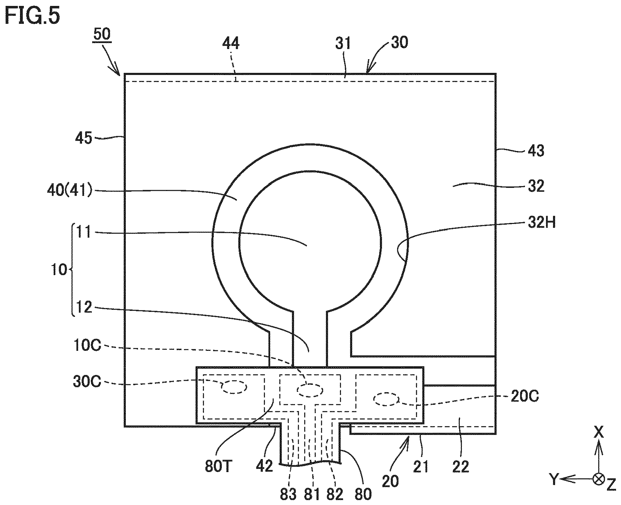

Piezoelectric element 50 includes three electrodes (not illustrated) (corresponding to electrodes 10 to 30 in Fig. 1, and details thereof will be described later). As illustrated in Fig. 5, a leading end portion 80T of FPC 80 has a T shape. FPC 80 is electrically bonded to these electrodes 10 to 30 with bonding agent 65 (Fig. 2) interposed therebetween. A resin material to which metal has been added is used as bonding agent 65, for example. A portion of FPC 80 on the side opposite to a portion thereof bonded to piezoelectric element 50 is extended to the outside of case 60 and is electrically connected to signal generation circuit 104 (Fig. 1), reception amplifier 106 (Fig. 1), and the like.

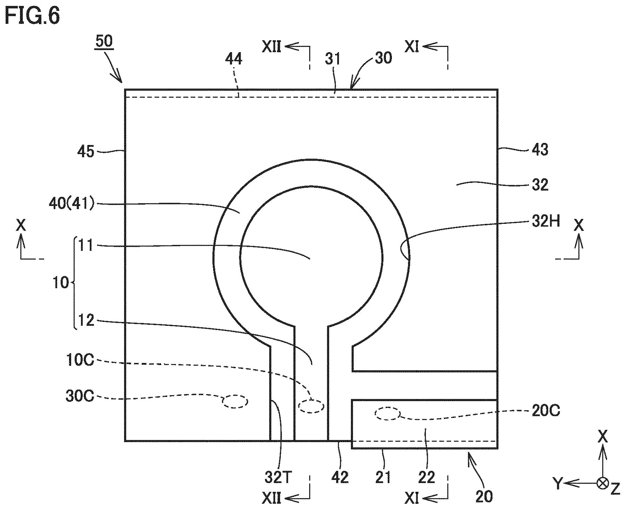

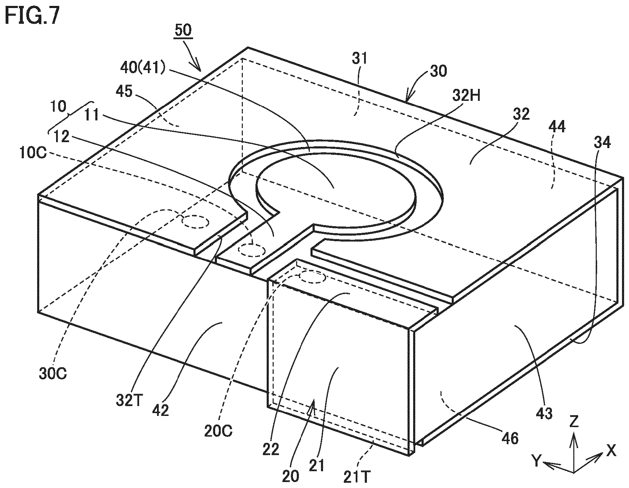

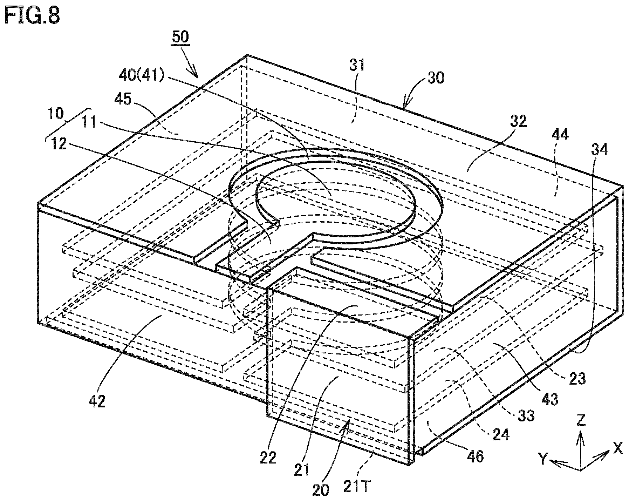

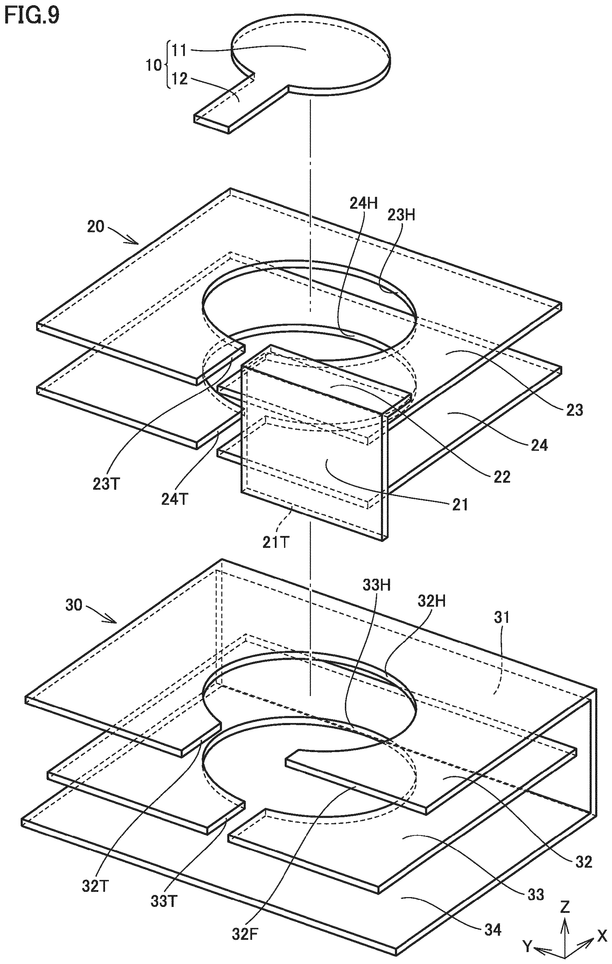

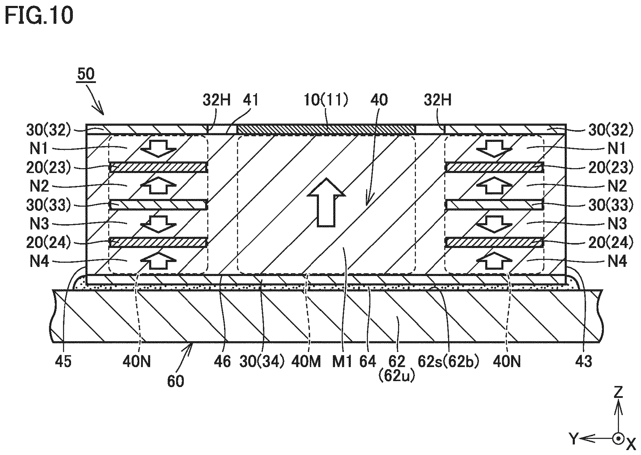

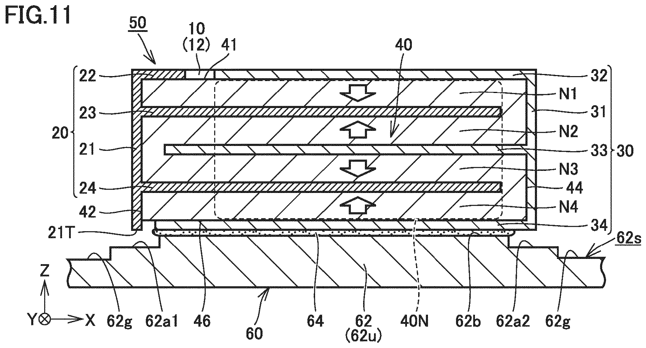

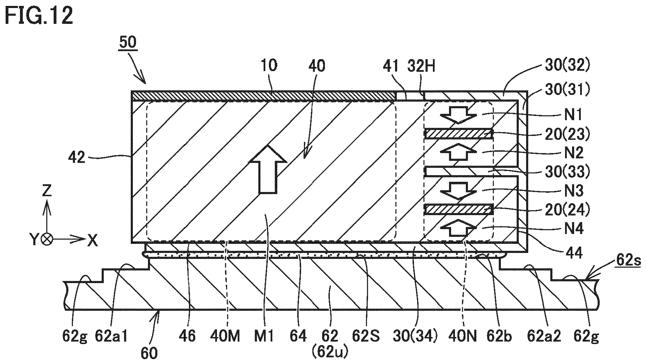

Fig. 5 is a plan view illustrating piezoelectric element 50 and FPC 80. Fig. 6 is a plan view illustrating piezoelectric element 50 (in a state in which FPC 80 is detached). Fig. 7 is a perspective view illustrating piezoelectric element 50. Fig. 8 is a perspective view illustrating piezoelectric element 50 and the internal structure thereof. Fig. 9 is a perspective view illustrating electrodes 10, 20, and 30 included in piezoelectric element 50. Fig. 10 is a cross-sectional view when seen in the arrow direction along a line X-X in Fig. 6 (and Fig. 3). Fig. 11 is a cross-sectional view when seen in the arrow direction along a line XI-XI in Fig. 6 (and Fig. 3). Fig. 12 is a cross-sectional view when seen in the arrow direction along a line XII-XII in Fig. 6 (and Fig. 3).

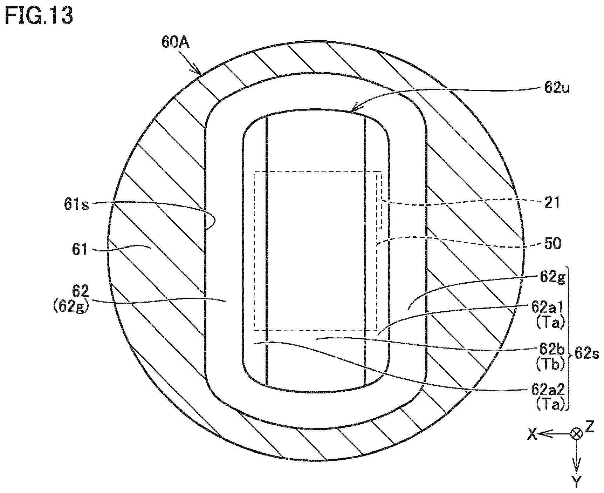

In Fig. 5 to Fig. 12, arrows X, Y, and Z are indicated for the convenience of description. Arrows X, Y, and Z have a relation of being orthogonal to one another. Hereinafter, the respective configurations of piezoelectric element 50 are described with reference to arrows X, Y, and Z in some cases. However, arrangement relations of the respective configurations (characteristics related to orthogonality and parallelism) are not necessarily limited to arrangement relations as indicated by arrows X, Y, and Z. The same applies as well to Fig. 2 to Fig. 4 described above and Fig. 13 to Fig. 17 described later.

As illustrated in Fig. 5 to Fig. 12, piezoelectric element 50 is a multilayer piezoelectric element and is attached to inner surface 62s (second top surface portion 62b) of case 60 using adhesive 64 (Fig. 10 to Fig. 12). Specifically, piezoelectric element 50 includes a piezoelectric layer 40 (Fig. 5 to Fig. 8 and Fig. 10 to Fig. 12), electrode 10 (Fig. 9), electrode 20 (Fig. 9) as a second electrode, and electrode 30 (Fig. 9) as a first electrode. The outer shape of piezoelectric layer 40 is a substantially rectangular parallelepiped shape (see Fig. 7 and Fig. 8) and piezoelectric layer 40 has an upper surface 41, side surfaces 42 to 45, and a lower surface 46.

Upper surface 41 is a surface of piezoelectric layer 40, which is located on the arrow Z direction side. Lower surface 46 is a surface of piezoelectric layer 40, which is located on the opposite direction side to the arrow Z direction. Side surfaces 42 and 44 are surfaces of piezoelectric layer 40, which are orthogonal to the arrow X direction, and have a positional relation of opposing each other. Side surfaces 43 and 45 are surfaces of piezoelectric layer 40, which are orthogonal to the arrow Y direction, and have a positional relation of opposing each other.

### (Electrode 10)

Electrode 10 includes a disk portion 11 and an extending portion 12 (see Fig. 9). Electrode 10 functions as a reception electrode. Extending portion 12 has a shape extending toward the outer side from the outer edge of disk portion 11. Extending portion 12 is arranged so as to extend toward the side on which side surface 42 of piezoelectric layer 40 is located from the side on which disk portion 11 is located. As illustrated in Fig. 5, electrode 10 and FPC 80 (wiring pattern 81) are electrically connected on a portion (connecting place 10C) between wiring pattern 81 provided in FPC 80 and extending portion 12 of electrode 10 (also see Fig. 6 and Fig. 7).

### (Electrode 20 (Second Electrode))

Electrode 20 as a second electrode includes an end face portion 21, an upper surface portion 22, and intermediate portions 23 and 24 (see Fig. 9). Electrode 20 functions as a transmission electrode. That is to say, electrode 20 forms a potential difference between electrode 20 and electrode 30 (first electrode) by application of a voltage to electrode 20. End face portion 21 opposes side surface 42 (Fig. 7) of piezoelectric layer 40 and makes contact with side surface 42. An end portion 21T of end face portion 21 is a section of electrode 20 which is located on the joining surface side (on the adhesive 64 side). End portion 21T has a shape extending along a part of a lower end portion of side surface 42 in the longer side direction of piezoelectric element 50. In the present embodiment and the embodiments described below, the above-described joining surface corresponds to the bonding surface in the claims.

Upper surface portion 22 of electrode 20 is provided being continuously connected to an end portion of end face portion 21 on the arrow Z direction side and is arranged on upper surface 41 of piezoelectric layer 40. Intermediate portions 23 and 24 are sections of electrode 20 which are arranged inside piezoelectric layer 40, and are not visually recognized in a state in which piezoelectric element 50 is completed (see Fig. 7). An intermediate portion 33 of electrode 30 is arranged between intermediate portion 23 and intermediate portion 24 (see Fig. 10 to Fig. 12, and the like).

Hollowed portions 23H and 24H (Fig. 9) and cutout portions 23T and 24T are provided on the inner sides of intermediate portions 23 and 24, respectively. As illustrated in Fig. 9 and Fig. 11, end portions (specifically, end portions on the side where end face portion 21 is located) of intermediate portions 23 and 24 in the direction opposite to arrow X are connected to end face portion 21. On the other hand, end portions of intermediate portions 23 and 24 in the arrow X direction are not connected to an end face portion 31 of electrode 30, which will be described later, and are separated from end face portion 31. As illustrated in Fig. 5, electrode 20 and FPC 80 (wiring pattern 82) are electrically connected on a portion (connecting place 20C) between wiring pattern 82 provided in FPC 80 and upper surface portion 22 of electrode 20 (also see Fig. 6 and Fig. 7).

### (Electrode 30 (First Electrode))

Electrode 30 as a first electrode includes end face portion 31, an upper surface portion 32, an intermediate portion 33, and a lower surface portion 34 (see Fig. 9). Electrode 30 functions as a common electrode. End face portion 31 opposes side surface 44 (Fig. 7) of piezoelectric layer 40 and makes contact with side surface 44. Lower surface portion 34 opposes lower surface 46 of piezoelectric layer 40 and makes contact with lower surface 46. Upper surface portion 32 is provided being continuously connected to an end portion of end face portion 31 on the arrow Z direction side and is arranged on upper surface 41 of piezoelectric layer 40. Intermediate portion 33 is a section of electrode 30 which is arranged inside piezoelectric layer 40, and is not visually recognized in the state in which piezoelectric element 50 is completed (see Fig. 7).

Hollowed portions 32H and 33H (Fig. 9) are provided on the inner sides of upper surface portion 32 and intermediate portion 33, respectively. Disk portion 11 of electrode 10 is arranged on the inner side of hollowed portion 32H (see Fig. 7). Cutout portions 32T and 33T are also provided on the inner sides of upper surface portion 32 and intermediate portion 33, respectively. Extending portion 12 of electrode 10 is arranged on the inner side of cutout portion 32T (see Fig. 7). A retracted portion 32F is provided on a portion of upper surface portion 32 in the direction opposite to arrow Y. Retracted portion 32F is a section for permitting arrangement of upper surface portion 22 of electrode 20.

As illustrated in Fig. 9 and Fig. 11, end portions of upper surface portion 32, intermediate portion 33, and lower surface portion 34 in the arrow X direction are connected to end face portion 31. On the other hand, end portions of upper surface portion 32, intermediate portion 33, and lower surface portion 34 in the direction opposite to arrow X are not connected to end face portion 21 of electrode 20 and are separated from end face portion 21. As illustrated in Fig. 5, electrode 30 and FPC 80 (wiring pattern 83) are electrically connected on a portion (connecting place 30C) between wiring pattern 83 provided in FPC 80 and upper surface portion 32 of electrode 30 (also see Fig. 6 and Fig. 7).

### (Transmission Region and Reception Region)

Referring to Fig. 10 to Fig. 12, a transmission region 40N and a reception region 40M are formed in piezoelectric layer 40. Transmission region 40N has a four-layer structure formed of first piezoelectric layers N1 to N4. First piezoelectric layers N1 to N4 are laminated in the direction of being distanced from bottom portion 62 of case 60 and are electrically connected in parallel by electrode 20 and electrode 30. Outlined arrows in Fig. 10 to Fig. 12 indicate polarization directions of the respective piezoelectric layers. On the other hand, reception region 40M has a one-layer structure formed of a second piezoelectric layer M1.

Lower surface portion 34 of electrode 30 has a shape extending over both transmission region 40N and reception region 40M. Upper surface portion 22 of electrode 20 opposes lower surface portion 34 of electrode 30 with transmission region 40N including first piezoelectric layers N1 to N4 interposed therebetween. Disk portion 11 of electrode 10 opposes lower surface portion 34 of electrode 30 with reception region 40M including second piezoelectric layer M1 interposed therebetween.

That is to say, a region between upper surface portion 22 of electrode 20 and lower surface portion 34 of electrode 30, a region between intermediate portion 23 of electrode 20 and upper surface portion 32 of electrode 30, and a region between intermediate portion 23 of electrode 20 and lower surface portion 34 of electrode 30 in piezoelectric layer 40 function as transmission region 40N. On the other hand, a region between disk portion 11 of electrode 10 and lower surface portion 34 of electrode 30 in piezoelectric layer 40 functions as reception region 40M.

As illustrated in Fig. 10 and Fig. 12, transmission region 40N and reception region 40M are formed at positions adjacent to each other in the surface direction (X-Y plane direction) of inner surface 62s (second top surface portion 62b) of bottom portion 62 of case 60. To be specific, reception region 40M is provided at a center portion of piezoelectric layer 40 and transmission region 40N is provided on a peripheral portion as an outer side portion relative to reception region 40M in the radial direction so as to surround reception region 40M.

As illustrated in Fig. 11 and Fig. 12, in piezoelectric element 50 configured as described above, lower surface portion 34 of electrode 30 (first electrode) and end portion 21T of end face portion 21 of electrode 20 (second electrode) are located on the joining surface side of piezoelectric element 50 (on the side of the surface of piezoelectric element 50 joined to bottom portion 62 of case 60). Lower surface portion 34 of electrode 30 is attached to bottom portion 62 (second top surface portion 62b) of case 60 using adhesive 64. As described above, electrode 20 forms a potential difference between electrode 20 and electrode 30 (first electrode) by application of a voltage to electrode 20. As a result, ultrasonic sensor 100 can transmit ultrasonic waves.

Referring to Fig. 3 (and Fig. 11), in a plan view of electrode 20 (second electrode), first top surface portion 62a1 and second top surface portion 62b along the direction perpendicular to second top surface portion 62b of case 60, end portion 21T of electrode 20 is located to overlap with first top surface portion 62a1 without overlapping with second top surface portion 62b. In other words, when end portion 21T is projected along the direction perpendicular to second top surface portion 62b of case 60, a projected image formed by the projection is located to overlap with first top surface portion 62a1 without overlapping with second top surface portion 62b.

### (Actions and Effects)

As described in the beginning, generally, the ultrasonic sensor is often used in a state in which, when subjected to the load from the outside, the load is likely to directly act on the ultrasonic sensor. Let us assume that protruding portion 62u is not provided on bottom portion 62 of case 60 and bottom portion 62 has only a thickness Tg (see Fig. 2) corresponding to annular groove portion 62g. In this case, when small stones and the like come flying and collide with bottom portion 62 of case 60 during traveling of a vehicle, for example, bottom portion 62 and piezoelectric element 50 bonded to bottom portion 62 may be damaged.

In contrast, in ultrasonic sensor 100 in the present embodiment, protruding portion 62u is provided on bottom portion 62 and bottom portion 62 has a thickness greater, by a thickness of protruding portion 62u, than thickness Tg corresponding to annular groove portion 62g. Therefore, ultrasonic sensor 100 is more resistant to impact than the above-described case, and thus, the occurrence of damage can be suppressed.

Simply increasing the thickness of bottom portion 62 may lead to a reduction in amplitude (i.e., deterioration in detection accuracy). In ultrasonic sensor 100, protruding portion 62u is provided at the position distanced from cylindrical portion 61 of case 60, and thus, annular groove portion 62g is formed and the rigidity of a part of bottom portion 62 is reduced. Annular groove portion 62g is a portion closer to a node of vibration than the position of protruding portion 62u, and the reduction in amplitude (i.e., deterioration in detection accuracy) can be suppressed by the presence of annular groove portion 62g. Reducing the rigidity of a part of bottom portion 62 by the presence of annular groove portion 62g leads to an increase in vibration area, and thus, the directivity can also be narrowed (e.g., approximately 2 to 3 deg).

When multilayer piezoelectric element 50 is joined to inner surface 62s of bottom portion 62 of case 60 having conductivity, electrode 30 (first electrode) and end portion 21T of electrode 20 (second electrode) that forms a potential difference between the first electrode and the second electrode by application of a voltage are located on the joining surface side of piezoelectric element 50. In a conventional ultrasonic sensor including a multilayer piezoelectric element, bottom portion 62 of case 60 having conductivity and the end portion of electrode 20 establish electrical conduction (short circuit) due to a short distance between bottom portion 62 of case 60 and the end portion of electrode 20, and a counter electrode circuit (an electrical circuit for forming the ultrasonic sensor) is not appropriately formed in some cases.

In contrast, in ultrasonic sensor 100 in the present embodiment, protruding portion 62u is provided on bottom portion 62 and first top surface portion 62a1 is formed on protruding portion 62u. Second top surface portion 62b to which piezoelectric element 50 is joined has a protrusion height higher than that of first top surface portion 62a1. End portion 21T of end face portion 21 is arranged so as to oppose first top surface portion 62a1, not to oppose second top surface portion 62b (see Fig. 11). Therefore, electrical conduction established by electrode 20 (second electrode) and case 60 can be suppressed by the presence of first top surface portion 62a1 formed on protruding portion 62u. Case 60 and electrode 20 are insulated from each other and a counter electrode circuit is formed. Therefore, ultrasonic sensor 100 can function appropriately and a probability of occurrence of initial failure immediately after manufacturing can be reduced. Electrode 30 as a first electrode and bottom portion 62 of case 60 may establish electrical conduction.

When ultrasonic sensor 100 is driven, piezoelectric element 50 performs bending vibration together with bottom portion 62. If first top surface portion 62a1 is not provided on protruding portion 62u, case 60 (protruding portion 62u) and electrode 20 may establish electrical conduction after the start of use due to the bending vibration, which may lead to occurrence of failure. According to ultrasonic sensor 100 in the present embodiment, the occurrence of such a trouble can also be suppressed by the presence of first top surface portion 62a1. The presence of protruding portion 62u and first top surface portion 62a1 may affect a vibration mode of ultrasonic sensor 100. Therefore, a shape, a depth (protrusion height), a length, a width and the like of each of protruding portion 62u and first top surface portion 62a1 may be optimized so as to prevent occurrence of unnecessary electrical conduction and obtain an optimum vibration mode.

Measures to prevent electrical conduction described in the first embodiment may also be taken by devising the shape of the piezoelectric element (e.g., electrode 20). However, it can be said that when a thin multilayer element is used, the measures to provide protruding portion 62u and first top surface portion 62a1 in case 60 as described in the present embodiment can be performed more easily. Furthermore, in addition to provision of protruding portion 62u and first top surface portion 62a1 in case 60, it is also effective to prevent occurrence of unnecessary electrical conduction by devising the shape of the piezoelectric element (e.g., electrode 20).

The general ultrasonic sensor including the multilayer piezoelectric element has the characteristics that as the number of laminated layers of the piezoelectric element is larger, the sound pressure in the transmission is increased whereas the sensitivity in the reception is decreased. The characteristics are provided because in the general multilayer piezoelectric element, a portion of the piezoelectric element which is provided for the transmission and a portion thereof which is provided for the reception are formed in the same section.

In the present embodiment, the portion (transmission region 40N) of piezoelectric element 50 that is provided for the transmission and the portion (reception region 40M) thereof which is provided for the reception are formed separately from each other. Accordingly, both the sound pressure in the transmission and the sensitivity in the reception can be adjusted independently of each other. In the present embodiment, the four-layer structure, in which the number of laminated layers is four, is employed for the portion (transmission region 40N) of piezoelectric element 50 which is provided for the transmission in order to increase the sound pressure in the transmission, whereas the one-layer structure is employed for the portion (reception region 40M) thereof which is provided for the reception. The ultrasonic sensor in the present embodiment suppresses lowering in the sensitivity in the reception in comparison with the conventional configuration.

### Experiment Example

In order to verify the effects produced by the above-described first embodiment, the following experiment was conducted. Specifically, a case having a diameter of 14 mm and a height of 9 mm was prepared as case 60 made of metal. Thickness Tg (thickness of the portion corresponding to annular groove portion 62g) of bottom portion 62 of case 60 was set at 0.9 mm. A shape of first top surface portions 62a1 and 62a2 provided on protruding portion 62u of bottom portion 62 was set to have a length of 6.5 mm, a width of 0.5 mm and a depth of 0.05 mm. A shape of annular groove portion 62g was set to have a width of 1.0 mm and a depth of 0.4 mm.

A piezoelectric element having a length of 6 mm, a width of 5 mm and a thickness of 0.2 mm was prepared as multilayer piezoelectric element 50. As the wiring member, a lead wire with a connector was used instead of the FPC, an epoxy resin (insulating adhesive) was used as adhesive 64, and silicone was used as fillers 71 and 72 (see Fig. 2). A plurality of ultrasonic sensors 100 each having the above-described configuration were manufactured. Then, the number of ultrasonic sensors 100 in which initial failure occurred (electrical conduction occurred immediately after manufacturing) was zero.

### Modification of First Embodiment

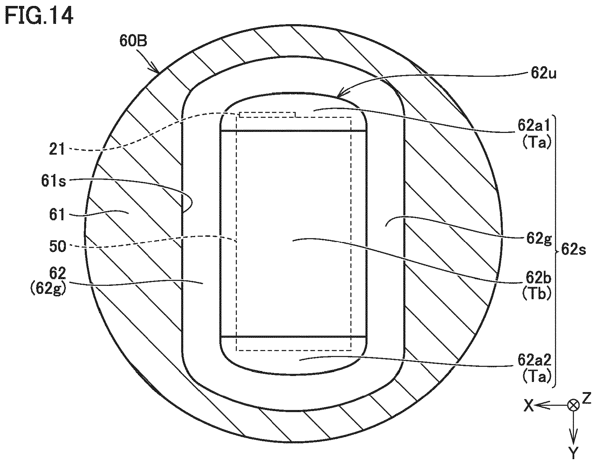

In the above-described first embodiment (see Fig. 3), two first top surface portions 62a1 and 62a2 and one second top surface portion 62b are formed on protruding portion 62u of bottom portion 62, and the central portion of piezoelectric element 50 is joined to second top surface portion 62b. Fig. 13 is a cross-sectional view illustrating a case 60A included in an ultrasonic sensor in a modification of the first embodiment. Fig. 13 corresponds to Fig. 3 in the above-described first embodiment. For the sake of convenience, piezoelectric element 50 is indicated by a dotted line in Fig. 13. The same applies as well to Fig. 14 to Fig. 17 described later.

In the case of case 60A illustrated in Fig. 13, in a plan view of first top surface portions 62a1 and 62a2 along an axial direction of case 60A, first top surface portions 62a1 and 62a2 are located at an end portion on one side (on the right side in the figure) in a shorter side direction of protruding portion 62u and at an end portion on the other side (on the left side in the figure) in the shorter side direction of protruding portion 62u, respectively, and extend in parallel to reach one side and the other side in a longer side direction of protruding portion 62u (along a top-and-bottom direction in the figure), respectively. Each of first top surface portions 62a1 and 62a2 has protrusion height Ta and second top surface portion 62b has protrusion height Tb. A value of protrusion height Tb is larger than a value of protrusion height Ta. In the present embodiment as well, second top surface portion 62b has a protrusion height higher than that of each of first top surface portions 62a1 and 62a2. With this configuration as well, actions and effects similar to those obtained in the above-described first embodiment are obtained.

### Second Embodiment

In the above-described first embodiment (see Fig. 3), two first top surface portions 62a1 and 62a2 and one second top surface portion 62b are formed on protruding portion 62u of bottom portion 62, and the central portion of piezoelectric element 50 is joined to second top surface portion 62b. Fig. 14 is a cross-sectional view illustrating a case 60B included in an ultrasonic sensor in a second embodiment.

In the case of case 60B illustrated in Fig. 14, in a plan view of first top surface portions 62a1 and 62a2 along an axial direction of case 60B, first top surface portions 62a1 and 62a2 are located at an end portion on one side (on the upper side in the figure) in a longer side direction of protruding portion 62u and at an end portion on the other side (on the lower side in the figure) in the longer side direction of protruding portion 62u, respectively, and extend in parallel to reach one side and the other side in a shorter side direction of protruding portion 62u (along a right-and-left direction in the figure), respectively. Each of first top surface portions 62a1 and 62a2 has protrusion height Ta and second top surface portion 62b has protrusion height Tb. A value of protrusion height Tb is larger than a value of protrusion height Ta.

In the present embodiment, end face portion 21 has a shape extending along a side surface of piezoelectric element 50 in the shorter side direction. Referring to Fig. 14, in a plan view of end face portion 21, first top surface portions 62a1 and 62a2, and second top surface portion 62b along a direction perpendicular to second top surface portion 62b of case 60B, end face portion 21 is located to overlap with first top surface portion 62a1 without overlapping with second top surface portion 62b. In other words, when end face portion 21 is projected along the direction perpendicular to second top surface portion 62b of case 60B, a projected image formed by the projection is located to overlap with first top surface portion 62a1 without overlapping with second top surface portion 62b. With this configuration as well, actions and effects similar to those obtained in the above-described first embodiment are obtained.

### Third Embodiment

In the above-described first embodiment (see Fig. 3), in a plan view of first top surface portions 62a1 and 62a2 along the axial direction of case 60, first top surface portions 62a1 and 62a2 each has a rectangular shape and extends in parallel (along the top-and-bottom direction in Fig. 3).

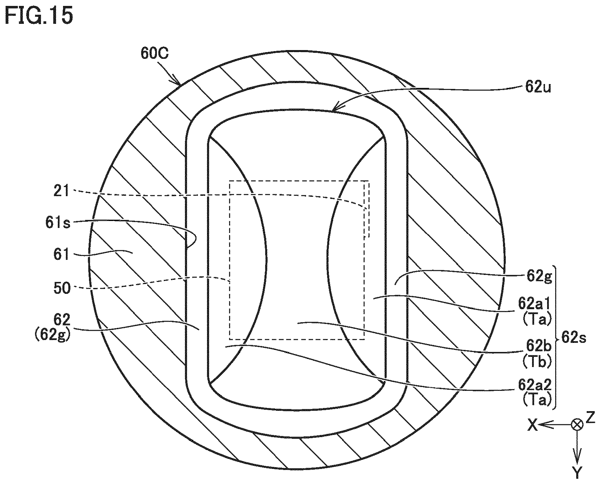

In the case of a case 60C illustrated in Fig. 15, first top surface portions 62a1 and 62a2 each has a semicircular shape. With this configuration as well, actions and effects similar to those obtained in the above-described first embodiment are obtained.

### Fourth Embodiment

In the above-described first embodiment (see Fig. 3), two first top surface portions 62a1 and 62a2 and one second top surface portion 62b are formed on protruding portion 62u of bottom portion 62, and the central portion of piezoelectric element 50 is joined to second top surface portion 62b.

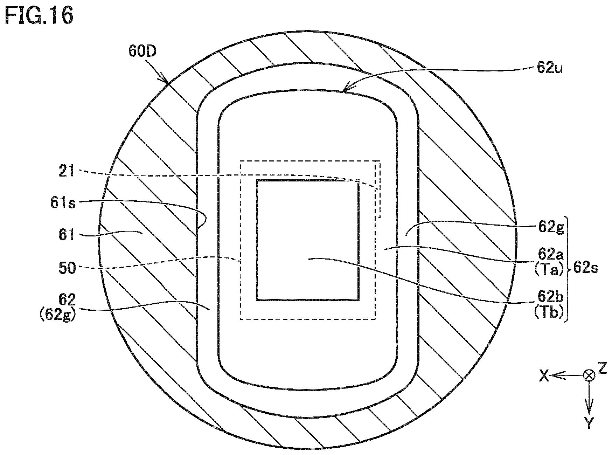

In the case of a case 60D illustrated in Fig. 16, one first top surface portion 62a and one second top surface portion 62b are formed on protruding portion 62u of bottom portion 62. In a plan view of piezoelectric element 50 and second top surface portion 62b along an axial direction (direction perpendicular to second top surface portion 62b) of case 60D, second top surface portion 62b is located on an inner side with respect to a peripheral edge of piezoelectric element 50. With this configuration as well, actions and effects similar to those obtained in the above-described first embodiment are obtained.

### Fifth Embodiment

In the above-described first embodiment (see Fig. 3), in a plan view of first top surface portions 62a1 and 62a2 along the axial direction of case 60, first top surface portions 62a1 and 62a2 are located at the end portion on the one side in the shorter side direction of protruding portion 62u and at the end portion on the other side in the shorter side direction of protruding portion 62u, respectively.

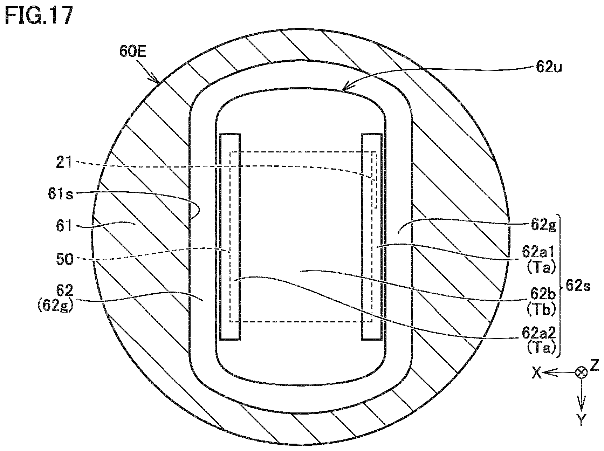

In the case of a case 60E illustrated in Fig. 17, in a plan view of first top surface portions 62a1 and 62a2 along an axial direction (direction perpendicular to second top surface portion 62b) of case 60E, first top surface portions 62a1 and 62a2 are located on an inner side with respect to a peripheral edge of second top surface portion 62b (protruding portion 62u). With this configuration as well, actions and effects similar to those obtained in the above-described first embodiment are obtained.

### Other Embodiments

Although piezoelectric element 50 is of multilayer type in each of the above-described embodiments, piezoelectric element 50 is not limited thereto. Piezoelectric element 50 may be of single-layer type. In addition, piezoelectric element 50 is not limited to the three-terminal structure and may have a two-terminal structure or a four-terminal structure. Although the piezoelectric element is made of PZT-based ceramics, the piezoelectric element is not limited to be made thereof. For example, the piezoelectric element may be made of a piezoelectric material of non-lead-based piezoelectric ceramics such as potassium sodium niobate-based ceramics, alkali niobate-based ceramics, or the like.

Although the piezoelectric element has a rectangular parallelepiped shape including a longer side direction and a shorter side direction in each of the above-described embodiments, the shape of the piezoelectric element is not limited thereto. For example, the piezoelectric element may have a substantially circular plate shape including an arc. Although fillers 71 and 72 (Fig. 2) are made of, for example, silicone resin in each of the above-described embodiments, fillers 71 and 72 are not limited to be made thereof. For example, fillers 71 and 72 may be made of urethane resin or silicone foam resin as long as they are made of resin.

Although one first top surface portion 62a or two first top surface portions 62a1 and 62a2 is/are provided on protruding portion 62u of bottom portion 62 in each of the above-described embodiments, three or more first top surface portions may be provided. When a plurality of first top surface portions are provided, protrusion heights (Ta) thereof may be the same or different from one another.

Although one second top surface portion 62b or two second top surface portions 62b1 and 62b2 is/are provided on protruding portion 62u of bottom portion 62 in each of the above-described embodiments, three or more second top surface portions may be provided. When a plurality of second top surface portions are provided, protrusion heights (Tb) thereof may be the same or different from one another.

Although the embodiments and the experiment example according to the present invention have been described above, the disclosure above is illustrative and not limitative in any respect. The technical scope of the present invention is defined by the claims.

### Reference Signs List

1 sensor device; 10, 20, 30 electrode; 10C, 20C, 30C connecting place; 11 disk portion; 12 extending portion; 21, 31 end face portion; 21T end portion; 22, 32 upper surface portion; 23, 24, 33 intermediate portion; 23H, 24H, 32H, 33H hollowed portion; 23T, 24T, 32T, 33T cutout portion; 32F retracted portion; 34 lower surface portion; 40, M1, N1, N2, N3, N4 piezoelectric layer; 40M reception region; 40N transmission region; 41 upper surface; 42, 43, 44, 45 side surface; 46 lower surface; 50 piezoelectric element; 60, 60A, 60B, 60C, 60D, 60E case; 60y opening; 61 cylindrical portion; 61s inner circumferential surface; 62 bottom portion; 62a, 62a1, 62a2 first top surface portion; 62b, 62b1, 62b2 second top surface portion; 62g annular groove portion; 62s inner surface; 62t outer surface; 62u protruding portion; 63 sound absorbing material; 64 adhesive; 65 bonding agent; 71, 72 filler; 80T leading end portion; 81, 82, 83 wiring pattern; 100 ultrasonic sensor; 101 microcomputer; 102 memory; 103 detecting circuit; 104 signal generation circuit; 105 power supply; 106 reception amplifier; Tg thickness; X, Y, Z arrow.

## Claims

1. An ultrasonic sensor (1) comprising:
a case (60, 60A, 60B, 60C, 60D, 60E) having a cylindrical shape with a bottom, the case including a bottom portion (62) and a cylindrical portion (61) and being formed of a member having electrical conductivity; and
a piezoelectric element (50) bonded to an inner surface of the bottom portion, the piezoelectric element being configured to perform bending vibration with the bottom portion,
a first electrode (30) and a second electrode (20) located on a bonding surface side of the piezoelectric element, wherein application of a voltage forms a potential difference between the first electrode and the second electrode,
the bottom portion of the case being provided with a protruding portion (62u) protruding toward an opening side of the case at a position distanced from the cylindrical portion of the case,
a top surface of the protruding portion including a first top surface portion (62a, 62a1, 62a2) and a second top surface portion (62b) having second protrusion height (Tb) higher than a first protrusion height (Ta) of the first top surface portion,
the piezoelectric element extends laterally beyond the second top surface portion in a surface direction of the second top surface portion, the piezoelectric element being arranged such that at least a part thereof overlaps with the second top surface portion.

2. The ultrasonic sensor according to claim 1, wherein
the piezoelectric element (50) is of multilayer type, and in a plan view of the second electrode (20), the first top surface portion (62a, 62a1, 62a2) and the second top surface portion (62b) along the direction perpendicular to the second top surface portion, an end portion of the second electrode located on the bonding surface side is located to overlap with the first top surface portion without overlapping with the second top surface portion.

3. The ultrasonic sensor according to claim 1 or 2, wherein
the piezoelectric element (50) has:
a piezoelectric layer (40) including a transmission region (40N) and a reception region (40M);
a common electrode (30) having a shape extending over both the transmission region and the reception region;
a transmission electrode (20) opposing the common electrode with the transmission region interposed therebetween; and
a reception electrode (10) opposing the common electrode with the reception region interposed therebetween, and
the transmission region and the reception region are formed at positions adjacent to each other in thesurface direction of the second top surface portion.

## Patentansprüche

1. Ultraschallsensor (1), der Folgendes aufweist:
ein Gehäuse (60, 60A, 60B, 60C, 60D, 60E), das eine zylindrische Form mit einem Boden hat, wobei das Gehäuse einen Bodenteil (62) und einen zylindrischen Teil (61) beinhaltet und aus einem Element gebildet ist, das elektrische Leitfähigkeit aufweist; und
ein piezoelektrisches Element (50), das an eine Innenfläche des Bodenteils angefügt ist, wobei das piezoelektrische Element zum Durchführen von Biegeschwingungen mit dem Bodenteil konfiguriert ist,
eine erste Elektrode (30) und eine zweite Elektrode (20), die auf einer Anfügungsflächenseite des piezoelektrischen Elements liegt, wobei das Anlegen einer Spannung eine Potentialdifferenz zwischen der ersten Elektrode und der zweiten Elektrode bildet,
der Bodenteil des Gehäuses mit einem vorspringenden Teil (62u) versehen ist, der an einer von dem zylindrischen Teil des Gehäuses beabstandeten Position in Richtung auf eine Öffnungsseite des Gehäuses vorsteht,
eine Oberseite des vorstehenden Teils einen ersten Oberseitenteil (62a, 62a1, 62a2) und einen zweiten Oberseitenteil (62b), der eine zweite Vorsprungshöhe (Tb) hat, die höher ist als eine erste Vorsprungshöhe (Ta) des ersten Oberseitenteils, beinhaltet,
das piezoelektrische Element sich in einer Oberflächenrichtung des zweiten Oberseitenteils seitwärts über den zweiten Oberseitenteil hinaus erstreckt, wobei das piezoelektrische Element so angeordnet ist, dass wenigstens ein Stück davon mit dem zweiten Oberseitenteil überlappt.

2. Ultraschallsensor nach Anspruch 1, wobei
das piezoelektrische Element (50) mehrschichtiger Art ist und
in einer Draufsicht der zweiten Elektrode (20), des ersten Oberseitenteils (62a, 62a1, 62a2) und des zweiten Oberseitenteils (62b) entlang der zu dem zweiten Oberseitenteil rechtwinkligen Richtung ein Endteil der zweiten Elektrode, der auf der Anfügungsflächenseite liegt, so liegt, dass er den ersten Oberseitenteil überlappt, ohne den zweiten Oberseitenteil zu überlappen.

3. Ultraschallsensor nach Anspruch 1 oder 2, wobei
das piezoelektrische Element (50) Folgendes hat:
eine piezoelektrische Schicht (40), die eine Senderegion (40N) und eine Empfangsregion (40M) enthält;
eine Masseelektrode (30), die eine Form hat, die sich sowohl über die Senderegion als auch die Empfangsregion erstreckt;
eine Sendeelektrode (20), die der Masseelektrode (30) gegenüberliegt, wobei die Senderegion zwischen ihnen angeordnet ist; und
eine Empfangselektrode (10), die der Masseelektrode (30) gegenüberliegt, wobei die Empfangsregion zwischen ihnen angeordnet ist, und
die Senderegion und die Empfangsregion an in der Oberflächenrichtung des zweiten Oberseitenteils nebeneinanderliegenden Positionen gebildet sind.

## Revendications

1. Capteur à ultrasons (1), comprenant :
un boîtier (60, 60A, 60B, 60C, 60D, 60E) ayant une forme cylindrique avec un fond, le boîtier comprenant une partie de fond (62) et une partie cylindrique (61) et étant formé d'un membre ayant une conductivité électrique ; et
un élément piézoélectrique (50) lié à une surface interne de la partie de fond, l'élément piézoélectrique étant configuré pour effectuer une vibration de flexion avec la partie de fond,
une première électrode (30) et une deuxième électrode (20) situées sur un côté de surface de liaison de l'élément piézoélectrique, dans lequel l'application d'une tension forme une différence de potentiel entre la première électrode et la deuxième électrode,
la partie de fond du boîtier étant pourvue d'une partie en saillie (62u) faisant saillie vers un côté d'ouverture du boîtier à une position distancée de la partie cylindrique du boîtier,
une surface supérieure de la partie en saillie comprenant une première partie de surface supérieure (62a, 62al, 62a2) et une deuxième partie de surface supérieure (62b) ayant une deuxième hauteur de saillie (Tb) plus haute qu'une première hauteur de saillie (Ta) de la première partie de surface supérieure,
l'élément piézoélectrique s'étend latéralement au-delà de la deuxième partie de surface supérieure dans une direction de surface de la deuxième partie de surface supérieure, l'élément piézoélectrique étant arrangé de telle sorte qu'au moins une partie de celui-ci chevauche la deuxième partie de surface supérieure.

2. Capteur à ultrasons selon la revendication 1, dans lequel
l'élément piézoélectrique (50) est du type multicouche, et dans une vue plane de la deuxième électrode (20), la première partie de surface supérieure (62a, 62a1, 62a2) et la deuxième partie de surface supérieure (62b) le long de la direction perpendiculaire à la deuxième partie de surface supérieure, une partie d'extrémité de la deuxième électrode située sur le côté de surface de liaison est située pour chevaucher la première partie de surface supérieure sans chevaucher la deuxième partie de surface supérieure.

3. Capteur à ultrasons selon la revendication 1 ou 2, dans lequel
l'élément piézoélectrique (50) a :
une couche piézoélectrique (40) comprenant une région de transmission (40N) et une région de réception (40M) ;
une électrode commune (30) ayant une forme s'étendant sur la région de transmission et la région de réception toutes les deux ;
une électrode de transmission (20) à l'opposé de l'électrode commune avec la région de transmission interposée entre elles ; et
une électrode de réception (10) à l'opposé de l'électrode commune avec la région de réception interposée entre elles, et
la région de transmission et la région de réception sont formées à des positions adjacentes l'une à l'autre dans la direction de surface de la deuxième partie de surface supérieure.
